(19) Europäisches Patentamt

European Patent Office

Office européen des brevets

(11) Veröffentlichungsnummer: **0 226 136 B1**

# (12) EUROPÄISCHE PATENTSCHRIFT

(45) Veröffentlichungstag der Patentschrift: **06.05.92**

(21) Anmeldenummer: **86116872.2**

(22) Anmeldetag: **04.12.86**

(51) Int. Cl.⁵: **H01L 21/00**

(54) Vorrichtung zum spanlosen Bearbeiten von Bauteilen.

(30) Priorität: **13.12.85 DE 3544087**

(43) Veröffentlichungstag der Anmeldung:
**24.06.87 Patentblatt 87/26**

(45) Bekanntmachung des Hinweises auf die
Patenterteilung:
**06.05.92 Patentblatt 92/19**

(84) Benannte Vertragsstaaten:
**AT BE CH DE FR GB IT LI NL SE**

(56) Entgegenhaltungen:
**EP-A- 0 116 447**

**TECHNICAL DIGEST, Nr. 24, Oktober 1971,
Seiten 21,22, New York, US; J.J. KOEHLER et
al.: "Lead trimming and assembling tool"**

(73) Patentinhaber: **AATEC Assembling-
Automations-Technik GmbH
Storchenweg 1
W-7530 Pforzheim(DE)**

(72) Erfinder: **Hinterlechner, Gerhard
Rote Turmstrasse 28/6
W-6940 Weinheim/Bergstrasse(DE)**

(74) Vertreter: **Ott, Elmar, Dipl.-Ing. et al
Kappelstrasse 8
W-7240 Horb 1(DE)**

Rank Xerox (UK) Business Services
(3.08/2.18/2.0)

## Beschreibung

Die Erfindung betrifft eine Vorrichtung gemäß der Gattung des Hauptanspruchs.

Beim Herstellen von insbesondere elektronischen Bauelementen, und hier insbesondere von integrierten Schaltungen, werden die Anschlußfahnen durch einen Umhüllvorgang bzw. Preßvorgang durch das Gehäuse verbunden. Dabei sind die einzelnen Anschlußfahnen über Verbindungsstege miteinander gekoppelt, welche eine Begrenzung für den zwischen die Anschlußfahnen einfließenden Kunststoff bilden. Diese Verbindungsstege müssen, da sie meist aus dem gleichen leitenden Material bestehen wie die Anschlußfahnen, nachträglich entfernt werden.

Bislang werden hierzu diese so hergestellten integrierten Halbleiterschaltungen auf eine Matrize aufgelegt, möglichst zentriert, und dann ein Stempel abgesenkt. Dieser Stempel weist eine Reihe zinnenartiger Vorsprünge auf, welche zwischen die Anschlußfahnen einfahren und dabei die Verbindungsstege herausstanzen. Die Führung dieses Stempelwerkzeuges geschieht bislang mittels Säulengestellen oder im Werkzeug integrierter Gleit- oder Rollenführungen mit runden Führungssäulen und -Buchsen. Dabei ist es notwendig, daß Matrize und Stempel exakt geführt werden, d.h., daß beispielsweise nur eine Gesamtabweichung der Stempel zur Matrize von wenigen $\mu$ m zulässig sind. Diese Abweichung entsteht durch zusammengesetzte Toleranzen der Werkzeugteile, dem Führungsspiel der Führungen unter Belastung und auftretenden Verbiegungen im Werkzeug beim Arbeitsvorgang (Schnitt- oder Stanzvorgang). Eine derart exakte Führung ist mit den oben genannten herkömmlichen Vorrichtungen nicht möglich.

Bei diesen bekannten Vorrichtungen müssen relativ große Massen bewegt und abgebremst werden, was die Geschwindigkeit, mit welcher die Vorrichtung bei Verwendung von mechanischen Pressen arbeitet, herabsetzt.

Aus der EP-A1-0 116 447 ist eine Vorrichtung zum Stanzen von streifenförmigem Material bekannt. Diese Vorrichtung besitzt einen Führungskanal für die beiden Werkzeughälften, welcher in einen ganzheitlichen Block als U-förmiger Kanal eingearbeitet ist. Für die Verwendung zum Freistanzen von Halbleiterbauelementen ist eine Werkzeugfläche von etwa 100 x 100 mm erforderlich, so daß der Führungskanal entsprechend groß ausgebildet sein müßte. Aus einem ganzheitlichen Block läßt sich jedoch ein derartig großer Führungskanal nicht mit der geforderten Genauigkeit herstellen, da unvermeidbare Fertigungstoleranzen und Passungsvorgaben des Führungskanals und der beiden Werkzeughälften für Gleitführungen berücksichtigt werden müssen, welche zusammen unvermeidlich in einem vergrößerten, nicht zulässigen Führungsspiel resultieren. Die bekannte Vorrichtung ist daher nur für verhältnismäßig grobe Stanzarbeiten geeignet.

Der Erfinder hat sich zum Ziel gesetzt, eine Vorrichtung der oben genannten Art zu entwickeln, welche eine hohe Lebensdauer aufweist, bei der Matrize und Stempel äußerst exakt geführt werden und welche mit einer hohen Geschwindigkeit arbeitet.

Die Lösung dieser Aufgabe erhält man durch die im Anspruch 1 angegebenen Merkmale. Die Vorrichtung ist ganz allgemein für Schnitt-, Stanz-, Präge- und Formbearbeitung geeignet. Durch diesen Aufbau der Lagerung werden die bewegten Massen verringert, so daß die Vorrichtung mit höherer Geschwindigkeit betreibbar ist. Die exakte Führung wird vor allem über den gemeinramen Führungsblock erzielt. Dieser muß daher eine äußerst exakte äußere Form bzw. einen äußerst exakten Querschnitt aufweisen. Die Herstellung eines derartigen Referenzblockes ist jedoch erfahrungsgemäß wesentlich einfacher zu erzielen als eine auf Dauer exakte Führung mit Säulenführungen. Die zusammengesetzten Toleranzen werden auf wenige Teile reduziert.

Zur Verbesserung der Führung von Matrizenblock bzw. Stempelführung auf dem Referenzblock ist erfindungsgemäß eine Rollenlagerung vorgesehen. Der Matrizenblock und die Stempelführung sind dabei in einem präzisen Gehäuse gelagert, welches aus Referenzblock, oberer und seitlichen Führungsplatten gebildet wird. Diese Zwangsführung von Matrizenblock bzw. Stempelführung verringert zum einen den Verschleiß, zum anderen den Toleranzbereich der Führung.

Der Matrizenblock selbst soll Aufnahmekanäle für Stempel aufweisen, wobei diese Aufnahmekanäle bevorzugt im Innern des Matrizenblocks in eine Kammer einmünden, an der eine Absaugeinrichtung angeschlossen werden kann. Werden Verbindungsstege von den Stempeln zwischen den Anschlußfahnen herausgestanzt und in die Aufnahmekanäle gestoßen, so können diese auf diese Art und Weise leicht beseitigt werden.

Im Einzelfall kann unter die obere Führungsplatte des Gehäuses eine zusätzliche Distanzplatte eingesetzt werden, welche durch eine keilförmige Ausführung den Raum für die Führung von Matrizenblock bzw. Stempelführung, selbstverständlich nur in einem sehr geringen Toleranzbereich, verringern kann, wodurch inmmer die gleiche Lagerung von Matrizenblock bzw. Stempelführung auf dem Referenzblock eingehalten wird und für Rollenlager eine Lagervorspannung eingestellt werden kann.

Die Stempelführung kann aus einem einstückigen Block oder einem Block mit austauschbaren Einsätzen ausgeführt sein. Bevorzugt soll die Stempelführung jedoch Führungsnuten aufweisen, in welchen Stempel gleitbar gelagert sind.

Die Kombi- oder Einzelstempel sollen erfindungsgemäß im Druckblock befestigt sein. In diesem Fall wird auch der Druckblock auf Rollenlager in einem Gehäuse angeordnet sein, so daß er zusammen mit der Stempelführung in Richtung y bewegt werden kann. Außerdem ist es dann möglich, in Stempelführung und/oder Druckblock Kraftspeicher anzuordnen, welche eine Rückführung der Stempel in die geschützte Lage in den Führungsnuten ermöglicht, gegen deren Druck jedoch die Stempel in Schließlage ausfahrbar sind. Sie dienen auch zum Abstreifen der Anschlußfahnen nach dem Stanzvorgang.

Um die Bewegung von Matrizenblock und Stempelführung bzw. Druckblock in Richtung x bzw. y zu ermöglichen, sind eine Reihe von Bewegungsmechanismen denkbar. Der im nachfolgend beschriebenen Ausführungsbeispiel aufgezeigte Bewegungsmechanismus stellt nur ein Ausführungsbeispiel dar. Dort erfolgt die Bewegung über zwei Nocken, welche zwei Hebel betätigen, die um ihre Drehachsen kippbar sind. Matrizenblock und Stempelführung bzw. Druckblock führen dabei eine durch die Nocken gesteuerte weiche Bewegung aus, welche aus einem geringen Hub besteht.

Insgesamt wird durch diese Vorrichtung eine Genauigkeit erreicht, welche mit einer Toleranz von wenigen µm anzugeben ist. Die Geschwindigkeit mit welcher die Vorrichtung arbeitet, liegt bei etwa fünf Schließungen pro Sekunde.

Weitere Module für zusätzliche Arbeitsvorgänge, wie Formen, Prägen, Tiefziehen können auf gleiche Weise in der Vorrichtung zusätzlich aufgebaut werden.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in

Fig. 1  einen Ausschnitt aus einer integrierten Halbleiterschaltung als Beispiel eines elektronischen Bauelements;

Fig. 2  eine perspektivische Ansicht von Grundelementen der erfindungsgemäßen Vorrichtung zum Bearbeiten elektronischer Bauelemente;

Fig. 3  einen Längsschnitt durch die erfindungsgemäße Vorrichtung zum Bearbeiten elektronischer Bauelemente;

Fig. 4  eine perspektivische Ansicht der Vorrichtung nach Fig. 3 mit einem schematisch dargestellten Bewegungsmechanismus;

Fig. 5  eine perspektivische Ansicht eines Ausschnitts aus einem Teil der Vorrichtung nach Fig. 3;

Fig. 6  eine perspektivische Ansicht eines weiteren Ausführungsbeispiels.

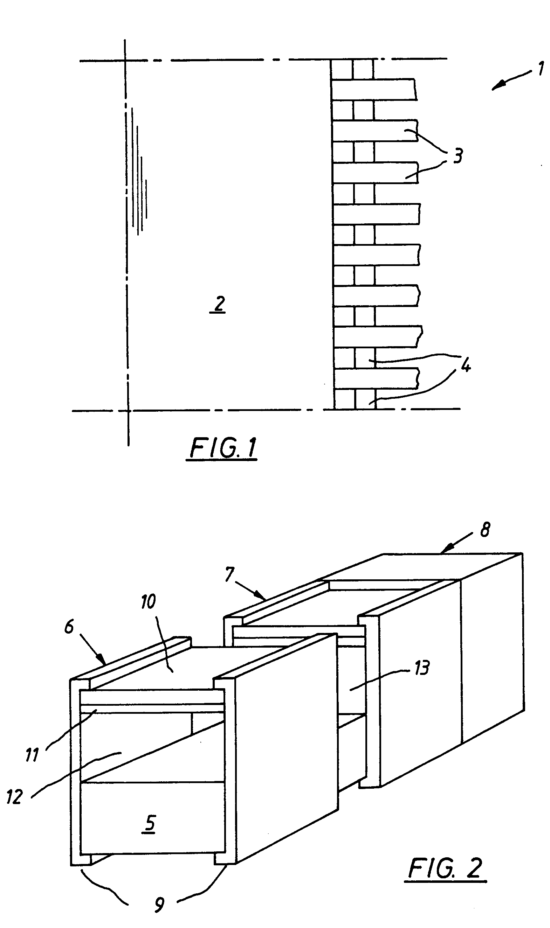

Gemäß Fig. 1 besteht ein Halbleiterbauteil 1 im wesentlichen aus einem Kunststoffgehäuse 2 mit randseitig angeformten, in der Regel metallischen Anschlußfahnen 3. Zwischen diesen Anschlußfahnen 3 befindet sich ein Verbindungssteg 4, welcher beim Umhüllungsvorgang von Anschlußfahnen 3 mit dem Kunststoffgehäuse 2 eine Begrenzung für den zwischen die Anschlußfahnen 3 einfließenden Kunststoff bildet. Aus fertigungstechnischen Gründen werden diese Verbindungsstege 4 in der Regel aus dem gleichen leitenden Material bestehen wie die Anschlußfahnen 3. Damit würden sie aber einen Kurzschluß zwischen den einzelnen Anschlußfahnen 3 herstellen, so daß sie vor einer weiteren Bearbeitung der integrierten Halbleiterschaltungen entfernt werden müssen.

Eine Vorrichtung zum Bearbeiten von in Fig. 1 gezeigten integrierten Halbleiterschaltungen weist gemäß Fig. 2 einen Führungs- bzw. Referenzblock 5 auf. Dieser durchsetzt drei Gehäuse 6, 7 und 8, wobei das Gehäuse 6 der Aufnahme eines Matrizenblocks, das Gehäuse 7 der Aufnahme eines Stempels und das Gehäuse 8 der Aufnahme eines zusätzlichen Druckblocks dient. Die Gehäuse 6,7 und 8 weisen klammerartige Seitenwände auf, welche jeweils den Referenzblock 5 unterfangen und eine Dachplatte 10 übergreifen. Unter der Dachplatte 10 kann eine weitere Distanzplatte 11 keilförmig angeordnet sein.

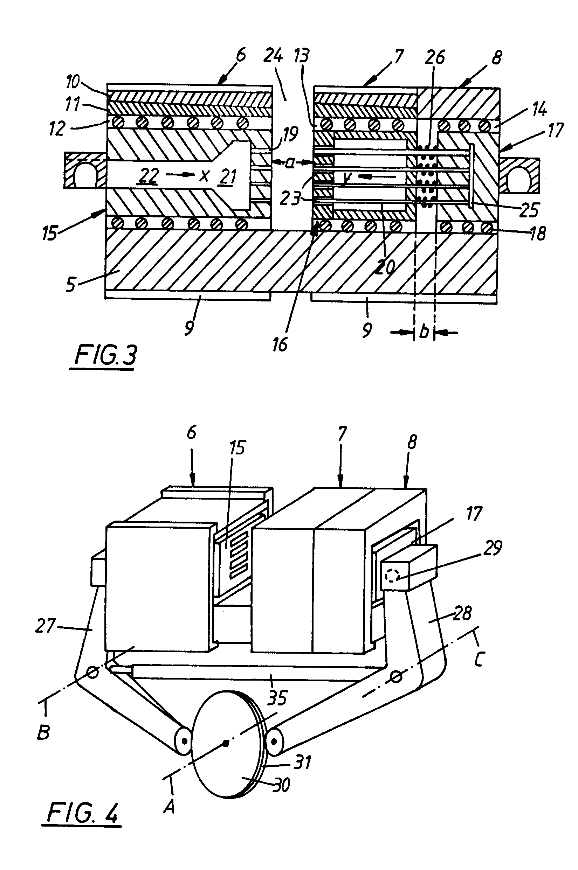

In allen drei Gehäusen 6,7 und 8 werden durch den Referenzblock 5 die Seitenwände 9 und die Distanzplatten 11 Aufnahmeräume 12,13 und 14 für die bewegbaren Elemente der erfindungsgemäßen Vorrichtung gebildet. Dabei dient der Raum 12 der Aufnahme eines Matrizenblocks 15, der Raum 13 der Aufnahme einer Stempelführung 16 und der Raum 14 der Aufnahme eines Druckblocks 17. Matrizenblock 15, Stempelführung 16 sowie gegebenenfalls Druckblock 17 sind allseitig zwischen Rollen 18 geführt, wobei der Übersichtlichkeit halber in Fig. 3 nur die unteren und die oberen Rollen angedeutet sind, während die seitlichen Rollen vernachlässigt werden.

Der Matrizenblock 15 oder gegebenenfalls der auswechselbare Einsatz weist Aufnahmekanäle 19 auf, in welche beim Stanzvorgang Stempel 20 aus der Stempelführung 16 eindringen können. Im vorliegenden Ausführungsbeispiel münden die Aufnahmekanäle 19 andererseits in eine Kammer 21, an welche ein Absaugkanal 22 zum Absaugen von herausgestanzten Verbindungsstegen 4 anschließt.

Die Stempel 20 sind in Führungsnuten 23 in der Stempelführung 16 geführt. Vorzugsweise sind zur Erhöhung der Genauigkeit die Führungsnuten 23 und die Aufnahmekanäle 19 in einem Arbeitsgang zusammen gefertigt. Zwischen der Stirnfläche des Matrizenblocks 15 mit den Aufnahmekanälen 19 und der Stirnfläche der Stempelführung 16 mit den Führungsnuten 23 wird eine Führungsrinne 24 der Breite a zur Aufnahme der Werkstückführung (Halbleiterführung) und zum Durchführen von beispielsweise integrierten Halbleiterschaltungen 1 gebildet.

Die Stempel 20 sind aus der Stempelführung 16 heraus in den Druckblock 17 geführt und dort durch eine Stempelplatte 25 befestigt. In Ruhelage hält ein Kraftspeicher 26 einen Abstand b zwischen der Stempelführung 16 und dem Druckblock 17.

Beim Stanzvorgang wird der Matrizenblock 15 in Richtung x und die Stempelführung 16 bzw. der Druckstempel 17 in Richtung y geführt. Dabei treffen Matrizenblock zuerst und dann die Stempelführung 16 auf ein in der Führungsrinne 24 geführtes Halbleiterbauteil 1. Dieses wird dabei genau zentriert. Der Druckblock 17 bewegt sich weiterhin in Richtung y und verkleinert dann den Abstand b gegen den Druck des Kraftspeichers 26. Hierdurch werden die Stempel 20 aus den Führungsnuten 23 herausgefahren, trennen die Verbindungsstege von den Anschlußfahnen 3 und gleiten, gegebenenfalls mit den Verbindungsstegen 4, in die Aufnahmekanäle 19 ein. Sodann werden Stempelführung 16, Druckblock 17 und dann Matrizenblock 15 entgegen der Richtung y bzw. x auseinander bewegt, so daß wiederum die Führungsrinne 24 entsteht und eine neue zu bearbeitende Halbleiterschaltung 1 eingeführt werden kann.

Für die Bewegung von Matrizenblock 15, Stempelführung 16 und Druckblock wird in Fig. 4 ein Beispiel angegeben. Dabei sind mit dem Matrizenblock 15 bzw. dem Druckblock 17 jeweils Hebel 27 und 28 verbunden, wobei diese Verbindung über einen Adapter 29 erfolgt. Andererseits des Adapters 29 greifen die Hebel 27 bzw 28 zwei Kurvenscheiben oder Nocken 30,31 an, die um eine Achse A drehen. Beim Ablaufen der Nocken 30,31 drehen die Hebel 27 bzw 28 um ihre im Bereich des Knies angeordneten Drehachsen B und C. Dadurch werden Matrizen- bzw Druckblock 15, 17 in Richtung x bzw y verschoben, wobei die jeweiligen Adapter 29 genügend Spiel aufweisen, um den Bewegungsspielraum der Hebel 27 bzw. 28 nicht zu beschränken. Die Rückstellung der Hebel 27 bzw. 28 an dem Nocken 30 kann durch Kraftspeicher 35 unterstützt werden. Ebenso ist es möglich, die Rückbewegung des Matrizenblocks 15 bzw. Druckblocks 17 in Richtung x bzw y durch zusätzliche Druckorgane zu unterstützen. Die Rückstellung kann aber auch über Nocken oder Kurvenscheiben gesteuert werden.

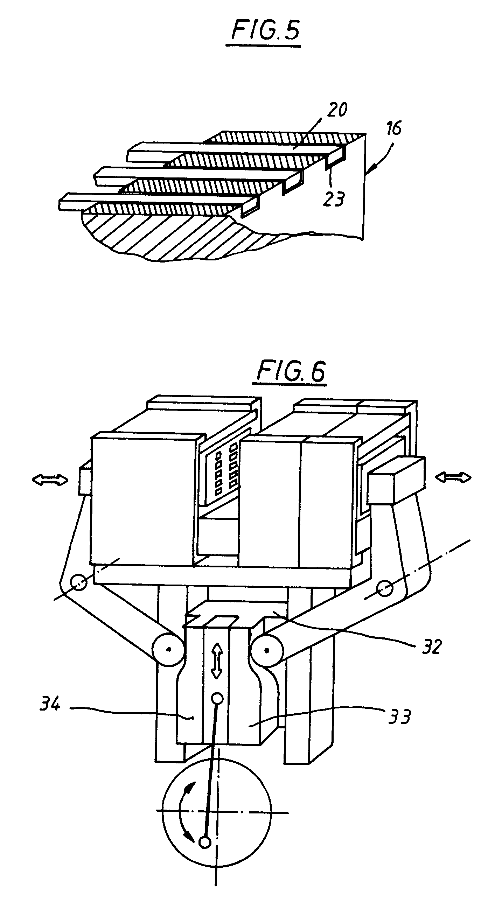

Die Figur 5 zeigt vergrößert Führungsnuten 23 sowie darin geführte Einzelstempel 20.

Bei dem in Fig. 6 dargestellten Ausführungsbeispiel erfolgt der Antrieb der Hebel 27, 28 mittels einer Nockenstange 32, die Kurven bzw. Nocken 33, 34 besitzt. Die verschiedenen Bewegungsrichtungen sind durch Pfeile angegeben.

**Patentansprüche**

1. Vorrichtung mit mindestens einem Modul für Schnitt-, Stanz-, Präge- oder Formbearbeitung von elektronischen, elektromechanischen oder mechanischen Bauteilen, insbesondere für das Herausstanzen von beim Herstellen von Halbleiterbauelementen (1) vorhandenen Verbindungsstegen (4) zwischen den Anschlußfahnen (3), mit einer Toleranz im Mikrometerbereich, wobei
   - jedes Modul einen Stempelführungsblock (16) mit Werkzeugstempeln (20) und einen Matrizenblock (15) mit Aufnahmekanälen (19) für die Werkzeugstempel aufweist,
   - der Stempelführungsblock und der Matrizenblock gegenüberliegend und gegenläufig bewegbar auf einer Bezugsebene, die die Oberfläche eines gemeinsamen Führungsblocks (5) bildet, angeordnet sind und zwischen ihren Stirnflächen eine Führungsrinne (24) zur Werkstückaufnahme frei lassen, und
   - der gemeinsame Führungsblock mit einer Dachplatte (10) sowie klammerartigen Seitenplatten, die jeweils den Führungsblock unterfangen und die Dachplatte übergreifen, ein Gehäuse (6, 7, 8) bildet, in dem Matrizenblock (15) und Stempelführungsblock (16) aufgenommen sind und sich allseits gegen Rollenlager (18) abstützen.

2. Vorrichtung nach Anspruch 1, **dadurch gekennzeichnet,** daß unter die Dachplatte (10) eine keilförmige Distanzplatte (11) eingesetzt ist, welche durch Längseinstellung den Raum (12) für den Matrizenblock (15) bzw. den Raum (13) für den Stempelführungsblock (16) präzise einstellt und für die Rollenlager die Lagervorspannung erzeugt.

3. Vorrichtung nach einem der Ansprüche 1 oder 2, **dadurch gekennzeichnet,** daß den Stempelführungsblock (16) stirnseitige Führungsnuten (23) aufweist, in welchen die Werkzeugstempel (20) gleitbar lagern.

4. Vorrichtung nach Anspruch 3, **dadurch gekennzeichnet,** daß die Werkzeugstempel (20) auf der der Stirnseite gegenüberliegenden Sei-

te aus dem Stempelführungsblock (16) herausragen und durch eine Stempelplatte (25) befestigt sind.

5. Vorrichtung nach Anspruch 4, **dadurch gekennzeichnet,** daß die Stempelplatte (25) in einem Druckblock (17) ruht, welcher gegen Rollenlager (18) abgestützt in einem Gehäuse (8) lagert und wie der Stempelführungsblock (16) in Längsrichtung verschiebbar ist.

6. Vorrichtung nach Anspruch 5, **dadurch gekennzeichnet,** daß zwischen Stempelführungsblock (16) und Druckblock (17) zumindest ein Kraftspeicher (26) angeordnet ist.

7. Vorrichtung nach einem der Ansprüche 1 bis 6, **dadurch gekennzeichnet,** daß dem Matrizenblock (15) und dem Stempelführungsblock (16) bzw. dem Druckblock (17) ein Bewegungsmechanismus mit geschlossenem Kraftkreis zugeordnet ist, welcher zangenartig arbeitet und die Werkzeuge in Längsrichtung hin und her bewegt.

8. Vorrichtung nach Anspruch 7, **dadurch gekennzeichnet,** daß Hebel (27, 28) mit eigenen Drehachsen (B, C) vorgesehen sind, die einen Antrieb über Nocken oder Kurven (30, 31, 33, 34) aufweisen und sowohl den Matrizenblock (15) als auch den Stempelführungsblock (16) zangenartig mit der Arbeitskraft beaufschlagen.

9. Vorrichtung nach Anspruch 8, **dadurch gekennzeichnet,** daß der Antrieb für die Hebel (27, 28) eine oder mehrere Kurvenscheiben (30, 31) aufweist, welche auf einer gemeinsamen Welle mit Drehachse (A) angeordnet sind.

10. Vorrichtung nach Anspruch 9, **dadurch gekennzeichnet,** daß eine gemeinsame Kurvenstange bzw. Nockenstange (32) mit beidseitig angeordneten Kurven bzw. Nocken (33, 34) die Hebel (27, 28) betätigt.

11. Vorrichtung nach einem der Ansprüche 8 bis 10, **dadurch gekennzeichnet,** daß zur Unterstützung der Bewegung des Matrizenblocks (15) und des Stempelführungsblocks (16) bzw. des Druckblocks (17) in ihre Schließlage bzw. Ausgangslage Kraftspeicher (35), im Bewegungsmechanismus vorgesehen sind.

**Claims**

1. Apparatus with at least one module for cutting, punching, stamping or shaping electronic, electromechanical or mechanical components, particularly for punching out the connecting webs (4) between the connecting lugs (3) present during the manufacture of semiconductor components (1) and with a tolerance in the micrometre range, each module having a punch guidance block (16) with tool punches (20) and a die block (15) with reception channels (19) for the tool punches, the punch guidance block and the die block face one another, moving in opposite directions on a reference plane forming the surface of a common guidance block (5) and between their end faces they leave free a guidance channel (24) for receiving work-pieces and the common guidance block, together with a coverplate (10) and clip-like side plates, which in each case underpin the guidance block and engage over the coverplate form a casing (6,7,8), which receives the die block (15) and the punch guidance block (16) and are supported on all sides against roller bearings (18).

2. Apparatus according to claim 1, characterized in that a wedge-shaped spacing plate (11) is inserted below the coverplate (10) and by means of a longitudinal setting precisely sets the area (12) for the die block (15) or the area (13) for the punch guidance block (16) and produces the bearing pretension for the roller bearings.

3. Apparatus according to one of the claims 1 or 2, characterized in that the punch guidance block (16) has frontal guidance grooves (23), in which are slideably mounted the tool punches (20).

4. Apparatus according to claim 3, characterized in that the tool punches (20) on the side opposite to the front project out of the punch guidance block (16) and are fixed by a punch plate (25).

5. Apparatus according to claim 4, characterized in that the punch plate (25) rests in a pressure block (17) which, supported against roller bearings (18), is mounted in a casing (8) and in the same way as the punch guidance block (16) is longitudinally displaceable.

6. Apparatus according to claim 5, characterized in that there is at least one force accumulator (26) between the punch guidance block (16) and the pressure block (17).

7. Apparatus according to one of the claims 1 to 6, characterized in that with the die block (15) and the punch guidance block (16) or the pressure block (17) is associated a movement mechanism with a closed force circuit, which functions in tong-like manner and reciprocates the tools longitudinally.

8. Apparatus according to claim 7, characterized in that levers (27,28) with their own rotation axes (B,C) are provided, which have a drive via cams or disk cams (30,31,33,34) and supply working force in tong-like manner to the die block (15) and the punch guidance block (16).

9. Apparatus according to claim 8, characterized in that the drive for the levers (27,28) has one or more cam disks (30,31), which are provided on a common shaft with the rotation axis (A).

10. Apparatus according to claim 9, characterized in that a common cam or cam disk rod (32) with cams or disk cams (33,34) arranged on either side actuates the levers (27,28).

11. Apparatus according to one of the claims 8 to 10, characterized in that for supporting the movement of the die block (15) and the punch guidance block (16) or the pressure block (17) in its closed or starting position, force accumulators (35) are provided in the movement mechanism.

**Revendications**

1. Dispositif comportant au moins un module pour le travail de coupe, d'estampage, de matriçage ou de formage de composants électroniques, électromécaniques ou mécaniques, en particulier pour découper par estampage, avec une tolérance de l'ordre du micromètre, des tiges (4) de liaison présentes, entre les barrettes (3) de raccordement, lors de la fabrication d'éléments (1) à semi-conducteur, dispositif dans lequel :

   chaque module présente un bloc (16) de guidage de poinçons avec des poinçons (20) et un bloc (15) de matrices avec des canaux (19) destinés à recevoir et loger les poinçons ;

   le bloc de guidage des poinçons et le bloc des matrices sont disposés l'un en face de l'autre et peuvent se déplacer en sens contraire sur un plan ou niveau de référence, qui forme la surface d'un bloc (5) de guidage commun, et ils laissent libre, entre leurs surfaces frontales, une gorge (24) de guidage destinée à recevoir les pièces à usiner, et

   le bloc de guidage commun forme, avec une plaque (10) de couverture ainsi qu'avec des plaques latérales en U, qui soutiennent à chaque fois le bloc de guidage et recouvrent la plaque de couverture, un boîtier (6, 7, 8), dans lequel le bloc (15) de matrices et le bloc (16) de guidage des poinçons sont logés et s'appuient de tous côtés contre un roulement (18) à rouleaux.

2. Dispositif selon la revendication 1, caractérisé en ce qu'une plaque (11) cunéiforme de maintien de distance est placée sous la plaque (10) de couverture et délimite de manière précise par réglage en longueur l'espace (12) destiné au bloc (15) des matrices ou l'espace (13) destiné au bloc (16) de guidage des poinçons et produit la précontrainte appliquée au roulement à rouleaux.

3. Dispositif selon l'une des revendications 1 ou 2, caractérisé en ce que le bloc (16) de guidage des poinçons présente des rainures (23) de guidage frontal, dans lesquelles les poinçons (20) sont montés coulissants.

4. Dispositif selon la revendication 3, caractérisé en ce que les poinçons (20) font saillie du bloc (16) de guidage des poinçons du côté opposé au côté frontal et sont fixés par une plaque (25).

5. Dispositif selon la revendication 4, caractérisé en ce que la plaque (25) de fixation des poinçons repose dans un bloc (17) de pression, qui est monté dans un boîtier (8) en appui contre des roulements (18) à rouleaux et qui peut coulisser dans le sens longitudinal comme le bloc (16) de guidage des poinçons.

6. Dispositif selon la revendication 5, caractérisé en ce qu'au moins un accumulateur (26) d'énergie est disposé entre le bloc (16) de guidage des poinçons et le bloc (17) de pression.

7. Dispositif selon l'une des revendications 1 à 6, caractérisé en ce qu'au bloc (15) des matrices et au bloc (16) de guidage des poinçons ou au bloc (17) de pression est associé un mécanisme de mouvement à circuit fermé d'énergie, lequel travaille à la manière de pinces ou languettes et soumet les outils à un mouvement alternatif dans le sens longitudinal.

8. Dispositif selon la revendication 7, caractérisé en ce que sont prévus des leviers (27, 28) ayant leurs propres axes (B, C) de rotation, qui présentent un entraînement par l'intermédiaire d'ergots ou saillies ou de cames (30, 31, 33, 34) et qui appliquent la force de travail, à la manière de pinces, aussi bien au bloc (15) des matrices qu'au bloc (16) de guidage des poinçons.

9. Dispositif selon la revendication 8, caractérisé en ce que l'entraînement des leviers (27, 28) présente un ou plusieurs disques (30, 31) à cames, qui sont disposés sur un arbre commun ayant un axe (A) de rotation.

10. Dispositif selon la revendication 9, caractérisé en ce qu'une tige à cames ou une tige à ergots (32) commune, comportant des cames ou ergots (33, 34) disposés des deux côtés, actionne les leviers (27, 28).

11. Dispositif selon l'une des revendications 8 à 10, caractérisé en ce que des accumulateurs (35) d'énergie sont prévus dans le mécanisme de mouvement pour faciliter le mouvement du bloc (15) des matrices et du bloc (16) de guidage des poinçons ou du bloc (17) de pression à leur position de fermeture ou à leur position de sortie ou de déploiement.

_FIG.1_

_FIG. 2_

*FIG. 3*

*FIG. 4*

## FIG.5

## FIG.6